# EUROPEAN PATENT SPECIFICATION

(11) **EP 2 898 333 B1**
(45) Date of publication and mention of the grant of the patent: **05.04.2023**
(21) Application number: 13766899.2
(22) Date of filing: 23.09.2013
(51) Int. Cl.: G01R 19/00, G01R 35/00, H01R 13/66

(54) **VOLTAGE SENSOR DEVICE**
SPANNUNGSSENSORVORRICHTUNG
DISPOSITIF DE DÉTECTION DE TENSION

(30) Priority: 24.09.2012 EP 12006671
(43) Date of publication of application: 29.07.2015
(73) Proprietor: ABB Schweiz AG, 5400 Baden (CH)
(72) Inventor: JAVORA, Radek, 664 62 Hrusovany u Brna (CZ); PAVLAS, Marek, 683 54 Otnice (CZ); HOZOI, Adrian, 68219 Mannheim (DE); PODZEMNY, Jaromir, 621 00 Brno (CZ)
(74) Representative: Maiwald GmbH
(86) International application number: PCT/EP2013/002857
(87) International publication number: WO 2014/044408

(56) References cited:
- WO-A1-03/012462
- DE-A1- 4 114 921
- US-A- 5 918 194
- US-A1- 2001 003 419
- US-A1- 2010 057 944
- Melexis Microelectronic Integrated Systems: "MLX91206 Triaxis® Current Sensor IC Datasheet Rev40", , 1 July 2012 (2012-07-01), XP002692838, Retrieved from the Internet: URL:http://www.melexis.com/Assets/MLX91206 -Datasheet-5942.aspx [retrieved on 2013-02-22]
- "KEVCD A, Indoor combined sensor; Indoor current sensor", , 30 April 2011 (2011-04-30), pages 1-8, XP055084794, Retrieved from the Internet: URL:http://www05.abb.com/global/scot/scot2 35.nsf/veritydisplay/17feb181c669c603c1257 8a1002aa24b/$file/KEVCD%20A_1VLC000588%20R ev.-%20en%202011.04.pdf [retrieved on 2013-10-22]

## Description

The invention relates to a voltage sensor device for use in medium- or high voltage application.

Melexis Microelectronic Integrated Systems: "MLX91206 IMC-Hall^{®} Current Sensor (Triaxis^{®} Technology) data sheet describes that the MLX91206 is a monolithic sensor IC featuring the Triaxis^{®} Hall technology.

The ABB data sheet "KEVCD A, Indoor combined sensor", 30 April 2011 (2011-04-30), pages 1-8, XP055084794, discloses a known combined voltage and current sensor.

US2010057944A1 describes a plug connector module having at least one plug connector for electromechanical connection with a field device, especially a device for measured data capture in process technology. The plug connector module includes a memory unit for storing data and a communication interface, which enables a data connection with the field device. It is described that addresses of participating field devices can be stored and/or transferred between different field devices. It is described that a service person connects the plug connector module with an already configured old field device, in order to store its data automatically locally in the plug connector module. Then, the service person connects the plug connector module with the new, not already configured, field device, in order to retrieve the configuration data stored locally in the plug connector module of the invention and to transfer such to the new field device. It is described that a manual configuration of the new field device, with the sources of error associated therewith, becomes unnecessary.

Voltage and/or current sensing devices in medium voltage networks in the state of the art might be easily standardized in their parameters and they can achieve high measuring accuracy, in case the electronic devices which are connected to said sensing devices enables the use of correction or calibration factors. These factors are specific to each single sensing device, calculated and/or measured during routine tests of these devices. These factors then need to be mentioned on a label of such devices and during installation of these devices, the factors need to be manually inserted into software of the connected electronic device. As there might be several digit number used as a calibration factor, it is not so difficult to make a mistake in writing the number into software of said electronic device, thus resulting in incorrect information processed within the measuring device. Same can happen in the case when the correction/calibration factor is integrated into actual transformation/division ratio of given device. In this case the actual transformation ratio might be a number of several digits that must be manually inserted into connected electronic device and mistake can easily occur during this process.

All electronical elements which are necessary for the aforesaid purpose are installed normally in a separate electronical calculation and display device.

Sensors are elements, which have to be calibrated, and each sensor needs its own set of calibration parameters or actual transformation ratio. So the central electronical calculation unit has to consider each individual sensor parameter set. So the accuracy of such sensors, depends on the effectivity of such parameter and data accuracy.

So it is an object of the invention to enhance the correspondence between the sensor and the electronical device, in order to use maximum possible accuracy potential of the voltage and/or current sensors.

This is solved by the subject matter of appended claim 1, where the sensor device output signal can be directly evaluated.

The invention and its scope of protection is defined in appended independent claim 1, with embodiments of the invention defined in the dependent claims.

The following disclosure enables the invention to be understood.

So it is realized, that each individual sensor is able to store its individual signal history as well as the individual calibration data set or actual transformation ratio information. This results furthermore in sensors with high accuracy.

Fortunately the housing can be a housing in form of a resin or plastic case filled by some material, that means that the sensor housing or the sensor device housing is made of a resin, or of plastic with a filling of insulating material.

This is easy to produce.

The voltage sensor device is equipped with a signal cable connector, and that the near to the sensor placed memory element is integrated in the signal cable connector equipped at the end of the output cable of the sensor device.

So the sensor device consists of a voltage sensor, a housing, an output cable, and a connector, placed at the end of the output cable.

It is preferred, that the memory element is connected to the sensor device. Therefore, there could be two locations. One is, to put it inside of the sensor device housing, and the other one is to place it in the boot of the connector.

But it could be, that the memory element is outside of the connector or sensor device housing and e.g. centralize all memory elements form all sensor devices in one substation. In that case the memory element could be located in some distance from the sensor device.

In the claimed invention, the signal and/or data memory element is integrated into the signal cable connector.

In a further advantageous embodiment, the device is equipped with, or embellished as a clamp-on connector boot in such a way, that integration of further sensor-relevant or sensor-signal-relevant elements are integrated inside this boot or connector, and that furthermore fixation for cable and connector connection can be used.

In a further advantageous embodiment to that, at least one impedance element, which is a secondary impedance element of a voltage divider of the voltage sensor is placed or integrated in that boot or connector, wherein the primary impedance element of the voltage divider is placed in the sensor device housing.

A connector boot in that sense is a connector housing.

The housing can be made of insulating material, or semiconductive material, or a conductive material.

The advantage for the use of semi-conductive or conductive material, is that by that a electromagnetic shielding is furthermore given.

In the claimed invention, the housing is made of insulating material.

In a further advantageous embodiment, the memory element is an Electrically Erasable

Programmable Read-Only Memory (EEPROM) element.

According to a method that is not part of the invention, the voltage sensor is equipped near the sensor location with an electronical, only to this individual sensor related data memory element, in such a way, that individual historical sensing data and/or individual calibration or parameter data are implemented into this data memory, and that this data memory corresponds automatically with a central calculation and/or monitoring device. In case more then one sensing device is connected to same electronic device, one memory element containing information related to all connected sensing devices can be used. In that case it has to be assured, that said sensing elements cannot be mixed and can be properly identified in order to assign correct parameters/correction data, stored in memory elment, to appropriate sensing element.

A further advantageous embodiment is given by that the correspondence between the data memory and the output evaluating device is operated via electrical wires, or via wireless access.

A final advantageous enhancement of the method is, that the data memory is furthermore equipped with an eletronical device in that way, that it retrieves its sensor data automatically after plug-on the cable to be sensored.

So the memory element is an Electrically Erasable Programmable Read-Only Memory (EEPROM) element, which is provided with correction factors of the premanufactured sensors, additionally to its function of storing measurement data.

The following figures are provided:
- Fig. 1:: Placement of memory element inside of th insulating body or in cavity of the voltage sensing device.
- Fig. 2:: Placement of the memory element outside of the insulating body of the voltage sensing device.
- Fig. 3:: RJ45 connector with clamp-on boot
- Fig. 4:: Placement of the secondary impedance element of the voltage divider

This invention proposes the use of memory element which can be used to store the data related to the voltage sensing devices. Such data could be directly read by the connected measuring devices, without the need for manual insertion of the data into the measurig device. Location of such memory element could be either in cavity of sensing device, where the output cable is being connected to as well, or at the end of the cable where connector is used to provide standardized termination or interface to the measuring devices.

An embodiment proposes the use of an additional memory element, such as EEPROM, which contains information about value of correction factor or actual transformation ratio. Information about correction factor or actual transformation ratio is inserted into the memory element during routine tests of the voltage and/or current sensing devices. This information will be read by the measuring devices, once they are connected to the voltage and/or current sensing elements, thus enabling precise transfer of the information about correction factor or factors or actual transformation ratio from the sensing device into the measuring device. Once this information enters the measuring device, it will be stored there and measuring device does not need to further communicate or transfer the information about correction factor or ratio again from the memory element inside of the sensing device.

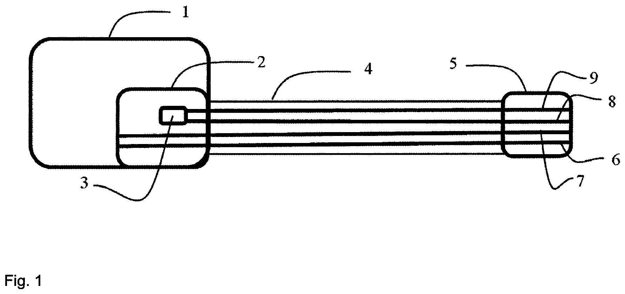

Memory element can store data about correction factors or actual transformation ratio, nevertheless once this device is used, it can cover and store much more information, such as serial number, type designation, production data, name of producer, parameters, dimensions, setting parameters, correction curves or look-up tables etc. Location of said memory element (3) can vary based on particular design of voltage and/or current sensing device (1). In case there is a need for strong mechanical protection, it is possible to place the memory element into the insulating body of voltage and/or current sensing device (1) or in cavity (2) that is later properly fixed or covered, see Fig. 1.

Access of the connected measuring device to the memory element (3) is done by means of one wire or more wires (8) and (9). Output wires (6) and (7) coming out of current and/or voltage sensing device are not affected by the signal going to/from said memory element (3). All wires (6), (7), (8) and (9) are located within the same connector, so once the sensing device is connected to the measuring device, connection to the memory element is enabled as well.

Common memory elements implement communication protocols such as I²C integrated circuits, or SPI (serial periperical interface bus) requiring 3 or more wires for the power supply of the memory element and for the data transfer. For simpler integration and lower costs it is preferred to reduce the number of wires required by the memory element. It is therefore beneficial to use a memory element where both the power supply function and the data transfer functions are achieved via one single wire such as in a 1-wire bus system.

Additionally, a temperature sensor may be installed in the sensor device sharing the same wires with the memory element. The temperature sensor may be included in the same integrated circuit with the memory element or in a separate integrated circuit.

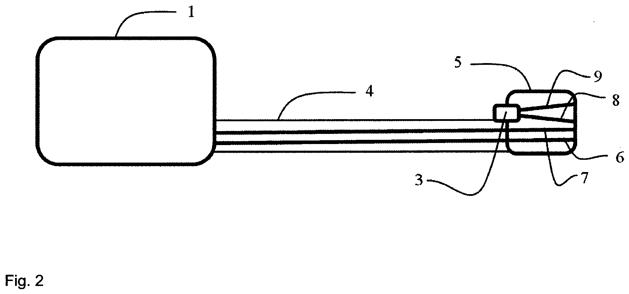

In case the insulating body of said sensing device exerts excessive mechanical pressure or temperature during production process or during operation, it is beneficial to locate the memory element outside of the insulating body. In case the output cable is a part of voltage sensing device, it might be possible to place the memory element at the end of that cable, simply there, where output wires of the sensing device might be easily accessible, see Fig. 2.

In case the memory element (3) is placed at the end of cable (4) and in case such end is equipped with connector (5), said memory element can be placed within the connector (5) or in connector boot.

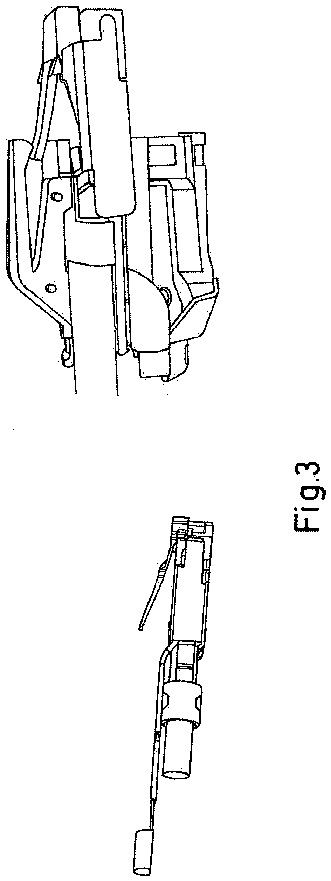

In one preferred embodiment, such connector (5) could be RJ45 connector, with clamp-on boot for insulation and mechanical protection of that connector, having a cavity, which enables insertion of a small memory element. See Fig. 3.

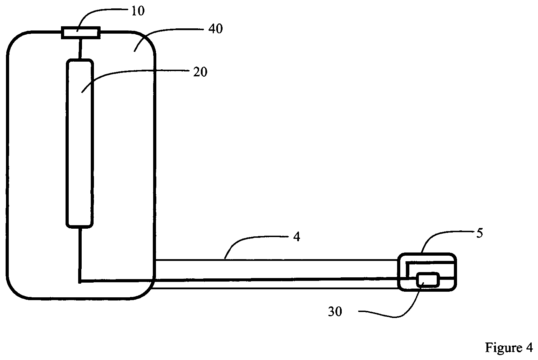

Figure 4 shows the housing of the sensor device 1 as in the claimed invention, in which a first voltage divider impedance 20 is located.

In this shown voltage detectors or indicators, secondary impedances are located outside of the body or housing 1, which contains primary impedance. Secondary impedance 30 is usually included inside of the electronic devices to which voltage detector is connected to. Only together, they can operate as voltage divider. As the products are usually produced separatelly, it is difficult to achieve very precise accuracy.

Therefore for a proper adjustment of voltage division accuracy after casting, it is the best to have both primary and secondary impedances aligned and tested together as one device.

As shown in that figure 4, a voltage sensing device consists of primary terminal 10, primary impedance 20, secondary impedance 30, insulating body 40, output cable 4 with two output wires and output connector 5. In an example not forming part of the claimed invention, the secondary impedance 30 is located in the separate connector boot, or a further intermediate terminal box. If so, the intermediate box requires additional connection of the output cable and secondary impedance 30 and it also needs to be subsequently covered to prevent from environmental influences and surrounding electric and/or magnetic fields in service. This may lead to higher costs of said device and also towards bigger or non-symmetric size of divider housing.

## Claims

1. A voltage sensor device (1) for use in medium- or high voltage application, the voltage sensor device (1) comprising:
a voltage sensor;
an insulating housing (40);
a signal cable connector (5);
an output cable (4); and
a signal and/or data memory element (3);
wherein, the output cable (4) is connected to the insulating housing (40)
wherein the signal cable connector (5) is connected to an end of the output cable (4) outside of the insulating housing (40);
wherein, the signal and/or data memory element (3) is integrated into the signal cable connector (5);
wherein, the signal and/or data memory element (3) is configured to store individual historical sensing data of the voltage sensor device (1) and store an individual calibration data set of the voltage sensor device (1) or an actual transformation ratio information of the voltage sensor device (1);
wherein, the voltage sensor comprises a voltage divider;
wherein the insulating housing has a primary terminal (10) of the voltage sensor;
wherein a primary impedance (20) of the voltage divider is located in the insulating housing and a first end of the primary impedance is connected to the primary terminal (10);
wherein a secondary impedance (30) of the voltage divider is located in the signal cable connector and a first end of the secondary impedance (30) is connected to a second end of the primary impedance through the output cable (4); and
wherein the signal cable connector (5) is configured to connect to a measuring device, wherein the signal cable connector (5) is configured to connect the measuring device to the signal and/or data memory element (3) and configured to connect the measuring device to the voltage divider.

2. Voltage device (1) according to claim 1, wherein the insulating housing (40) is made of a resin, or of plastic with a filling of insulating material.

3. Voltage sensor device (1) according to one of the aforesaid claims, wherein the memory element is an Electrically Erasable Programmable Read-Only Memory, EEPROM, element, which is provided with correction and/or calibration factors of the manufactured sensors and/or with additional data, additionally to its function of storing measurement data.

## Patentansprüche

1. Spannungssensorvorrichtung (1) zur Verwendung in Mittel- oder Hochspannungsanwendungen, wobei die Spannungssensorvorrichtung (1) Folgendes umfasst:
einen Spannungssensor;
ein Isoliergehäuse (40);
einen Signalkabelverbinder (5);
ein Ausgangskabel (4); und
ein Signal- und/oder Datenspeicherelement (3);
wobei das Ausgangskabel (4) mit dem Isoliergehäuse (40) verbunden ist;
wobei der Signalkabelverbinder (5) mit einem Ende des Ausgangskabels (4) außerhalb des Isoliergehäuses (40) verbunden ist;
wobei das Signal- und/oder Datenspeicherelement (3) in den Signalkabelverbinder (5) integriert ist;
wobei das Signal- und/oder Datenspeicherelement (3) so ausgebildet ist, dass es individuelle historische Abtastdaten der Spannungssensorvorrichtung (1) speichert und einen individuellen Kalibrierungsdatensatz der Spannungssensorvorrichtung (1) oder eine aktuelle Transformationsverhältnisinformation der Spannungssensorvorrichtung (1) speichert;
wobei der Spannungssensor einen Spannungsteiler umfasst;
wobei das Isoliergehäuse einen Primäranschluss (10) des Spannungssensors aufweist;
wobei eine Primärimpedanz (20) des Spannungsteilers in dem Isoliergehäuse angeordnet ist und ein erstes Ende der Primärimpedanz mit dem Primäranschluss (10) verbunden ist;
wobei eine Sekundärimpedanz (30) des Spannungsteilers in dem Signalkabelverbinder angeordnet ist und ein erstes Ende der Sekundärimpedanz (30) mit einem zweiten Ende der Primärimpedanz über das Ausgangskabel (4) verbunden ist; und
wobei der Signalkabelverbinder (5) so ausgebildet ist, dass er mit einer Messvorrichtung verbunden werden kann, wobei der Signalkabelverbinder (5) so ausgebildet ist, dass er die Messvorrichtung mit dem Signal- und/oder Datenspeicherelement (3) verbindet und so ausgebildet ist, dass er die Messvorrichtung mit dem Spannungsteiler verbindet.

2. Spannungsvorrichtung (1) nach Anspruch 1, wobei das Isoliergehäuse (40) aus einem Harz oder aus Kunststoff mit einer Füllung aus Isoliermaterial hergestellt ist.

3. Spannungssensorvorrichtung (1) nach einem der vorhergehenden Ansprüche, wobei das Speicherelement ein elektrisch löschbares, programmierbares Festwertspeicherelement (EEPROM) ist, das zusätzlich zu seiner Funktion, Messdaten zu speichern, mit Korrektur- und/oder Kalibrierfaktoren der hergestellten Sensoren und/oder mit zusätzlichen Daten versehen ist.

## Revendications

1. Dispositif capteur de tension (1) destiné à une utilisation dans une application de tension moyenne ou élevée, le dispositif capteur de tension (1) comprenant :
un capteur de tension ;
un boîtier isolant (40) ;
un connecteur de câble de signal (5) ;
un câble de sortie (4) ; et
un élément de mémoire de signal et/ou de données (3) ;
le câble de sortie (4) étant connecté au boîtier isolant (40) ;
le connecteur de câble de signal (5) étant connecté à une extrémité du câble de sortie (4) à l'extérieur du boîtier isolant (40) ;
l'élément de mémoire de signal et/ou de données (3) étant intégré dans le connecteur de câble de signal (5) ;
l'élément de mémoire de signal et/ou de données (3) étant configuré pour stocker des données de détection historiques individuelles du dispositif capteur de tension (1) et stocker un ensemble de données de calibrage individuelles du dispositif capteur de tension (1) ou des informations de rapport de transformation actuelles du dispositif capteur de tension (1) ;
le capteur de tension comprenant un diviseur de tension ;
le boîtier isolant comportant une borne primaire (10) du capteur de tension ;
une impédance primaire (20) du diviseur de tension étant située dans le boîtier isolant et une première extrémité de l'impédance primaire étant connectée à la borne primaire (10) ;
une impédance secondaire (30) du diviseur de tension étant située dans le connecteur de câble de signal et une première extrémité de l'impédance secondaire (30) étant connectée à une deuxième extrémité de l'impédance primaire à travers le câble de sortie (4) ; et
le connecteur de câble de signal (5) étant configuré pour se connecter à un dispositif de mesure, le connecteur de câble de signal (5) étant configuré pour connecter le dispositif de mesure à l'élément de mémoire de signal et/ou de données (3) et configuré pour connecter le dispositif de mesure au diviseur de tension.

2. Dispositif de tension (1) selon la revendication 1, le boîtier isolant (40) étant composé d'une résine ou de plastique avec un remplissage de matériau isolant.

3. Dispositif capteur de tension (1) selon l'une des revendications précédentes, l'élément de mémoire étant un élément de mémoire morte programmable effaçable électriquement, EEPROM, qui est doté de facteurs de correction et/ou de calibrage des capteurs fabriqués et/ou de données supplémentaires, en plus de sa fonction de stockage des données de mesure.
